(19) Europäisches Patentamt
European Patent Office
Office européen des brevets

(11) EP 0 861 513 B1

(12) EUROPEAN PATENT SPECIFICATION

(45) Date of publication and mention of the grant of the patent:
**04.07.2001 Bulletin 2001/27**

(21) Application number: **96938318.1**

(22) Date of filing: **13.11.1996**

(51) Int Cl.[7]: **H01S 3/23**, G02F 2/00

(86) International application number:
**PCT/GB96/02761**

(87) International publication number:
**WO 97/19504 (29.05.1997 Gazette 1997/23)**

(54) **FREQUENCY SYNTHESIZER**

FREQUENZSYNTHETISIERER

SYNTHETISEUR DE FREQUENCES

(84) Designated Contracting States:
**DE FR GB NL**

(30) Priority: **17.11.1995 GB 9523518**

(43) Date of publication of application:
**02.09.1998 Bulletin 1998/36**

(73) Proprietor: **The Secretary of State for Defence**
**Farnborough, Hampshire GU14 0LX (GB)**

(72) Inventors:
- **ETEM, Yvonne**
  **Malvern, Worcs. WR14 3PS (GB)**
- **LEWIS, Meirion, Francis**
  **Malvern, Worcs. WR14 3PS (GB)**

(74) Representative: **Skelton, Stephen Richard**
**Ministry of Defence**
**Directorate of Intellectual Property Rights**
**Formalities Section**
**Poplar 2**
**MOD Abbey Wood 19**
**Bristol BS34 8JH (GB)**

(56) References cited:

| | |
|---|---|
| **EP-A- 0 352 747** | **GB-A- 2 182 801** |
| **US-A- 5 204 640** | **US-A- 5 379 309** |

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 861 513 B1

## Description

This invention relates to frequency synthesizers and their stability. Fluctuations in phase of an oscillator can also be interpreted as frequency fluctuations, and in this document no distinction is made between frequency and phase fluctuations. This phase/frequency relationship is described in "Frequency Analysis Modulation and Noise", Chapter V, Modulation, by Stanford Goldman, McGraw-Hill (1948).

Frequency synthesizers are well known devices which are arranged to provide an output signal which has a frequency selected from a discrete set of values. Frequency synthesizers may use a frequency discriminator to maintain the stability of the selected frequency of the output signal.

An example of a simple frequency discriminator is shown in "Electricity and Magnetism" by B.I. Bleaney and B.Bleaney, page 581, Third Edition, Oxford University Press 1983. This device is an LC circuit discriminator, where L and C are circuit components having inductance L and capacitance C respectively. An oscillator output signal is input to the discriminator, which produces an output signal dependent on the input frequency, and thus can be used to control the oscillator output frequency in a feedback control loop. Such a discriminator is suitable for operation at a single frequency only. It is not suitable for use with a multi-frequency synthesizer.

Frequency discriminators are known for use in feedback control loops. Feedback control loops are systems in which an output signal is fed back into an input of the system to modify the system characteristics. In such feedback systems, "positive feedback" occurs if the signal fed back to the input causes an increase in output signal as occurs in oscillators; and "negative feedback" occurs if it causes a decrease in output signal. Negative feedback effects are used to stabilise circuits such as amplifier circuits.

Such discriminator feedback loops are known for use in stabilising outputs from frequency sources; such as voltage controlled oscillators (VCOs). However, changes in ambient temperature can result in drifting of the values of impedance and capacitance of the components of prior art frequency discriminators. This can cause the output of the frequency discriminator to drift and consequently the output frequency of the source can drift.

A further form of VCO involves the use of two high frequency oscillators, at least one of which is tuneable, to produce a tuneable output beat frequency. The VCO may comprise two lasers, whose radiation is mixed to produce a microwave beat frequency. The effect of temperature drift is particularly pronounced for sources based on laser mixing. The frequency of radiation from a laser operating at 1.3 µm is approximately $3 \times 10^{14}$ Hz, and a drift of only one part per million can result in changes in beat frequency of 300 MHz. Drifts of this magnitude can be a significant proportion of the intended operating microwave frequency of the source, and thus are undesirable, and even intolerable, when used in a system requiring a stable frequency source.

A fibre-optic stabilized electronic oscillator is described by R.T.Logan, Jr. et al. in the Proceedings of the 45th Annual IEEE Frequency Control Symposium, pp 508-512, 1991. The Logan device comprises a VCO having an output which is passed to a fibre-optic discriminator which in turn provides a frequency control to the VCO via a loop filter. The fibre-optic discriminator splits an RF input signal into two, one part of which is converted to a modulated optical signal and delayed using a fibre-optic delay line and then converted back to an electrical signal by a photodiode receiver and one part of which is passed through a phase shifter. The two parts are then compared by a phase detector which outputs a voltage dependent on the phase difference between the two parts. The fibre-optic delay line comprises a laser diode producing a modulated optical signal which is fed to a length of single-mode optical fibre. The performance of the Logan device is limited by the fibre-optic discriminator noise. The Logan paper suggests that the system may be improved by the use of diode pumped solid-state lasers and external intensity modulators in order to increase the signal to noise ratio. The Logan device suffers from the disadvantage that in order to use a fibre optic delay line to stabilise an oscillator, the RF oscillator signal must be converted from an electrical signal to an optical signal and thence back to an electrical signal.

In a further paper by Logan et al., published in the Proceedings of the 1992 IEEE Frequency Control Symposium 27-29 May 1992, pages 420-424, an ultrastable microwave and millimetre wave photonic oscillator is described. The device described therein is similar to that discussed previously but has a self-mode-locked laser diode acting as a source of microwave or millimetre wave signals. There is no discussion in this paper of adapting the device to provide a output signals over a frequency range, other than the behaviour of the mode-locked laser as a frequency multiplier.

A further oscillator device from Logan is described in United States Patent 5,379,309. The device described therein incorporates two injection locked lasers which are fed with an optical signal from an actively mode-locked laser oscillator. Each of the injection locked lasers receives a separate optical mode signal from the mode-locked laser. The outputs of the two injection locked lasers are combined to produce an output signal whose frequency is equal to the difference in frequency between the respective two modes received by the injection locked lasers from the mode-locked laser. Tuning of the synthesizer output may be obtained by tuning one of the injection locked lasers whilst keeping the second at a fixed frequency. The presence of a tuning facility for the lasers introduces the possibility of a lack of stability in the output of the synthesizer, arising, for example, as a result of thermal drift of the lasers. This patent is directed towards a device which is arranged to reduce phase noise of two lasers operating at different frequencies rather than the frequency instability of the device.

It is an object of the invention to provide an alternative form of frequency synthesizer.

The present invention provides a frequency synthesizer for producing an output signal, characterized in that the synthesizer comprises:

(i) two coherent optical sources, each for generating a respective radiation beam and having an adjustable radiation output frequency, the respective radiation beams being of differing frequency;
(ii) a beam combiner for combining the two radiation beams to produce two modulated optical signals, the optical signals having a modulation frequency;
(iii) means for delaying one of the modulated optical signals relative to the other; and
(iv) control means for controlling the optical sources in response to a detected modulation phase difference between the relatively delayed modulated optical signals.

The use of means for delaying an optical signal allows for frequency synthesizers to be made which are physically smaller than corresponding synthesizers with conventional delay lines such as co-axial cables.

The invention may be used for controlling the output frequencies from HF to millimetric radiation generated by the mixing of radiation from two lasers. HF radiation has a frequency in the range from 3 MHz to 30 MHz.

In a preferred embodiment the frequency synthesizer includes a fibre optic delay line providing the relative delay of one of the optical signals, with the length of the delay line determining the frequency separation of stable frequencies. The combination of wide bandwidth of mixed laser radiation with high degree of phase stability and the wide bandwidth capability of the optical fibre delay means enables the frequency of the mixed radiation to be tuned and stabilized over a wide range of frequencies.

The control means of the synthesizer may comprise two detectors for receiving the modulated optical signals and for producing respective detector output signals; a phase detector responsive to any phase difference between the detector output signals for producing an output in response thereto and means responsive to the phase detector output for controlling the optical sources. The phase detector may provide a negative feedback signal to the means responsive thereto.

Prior art frequency synthesizers incorporating a feedback loop suffer from the disadvantage that to achieve high precision a high gain is required in the feedback loop. This requirement is reduced when using lasers in the synthesizer of the invention because of the great sensitivity of the beat frequency to a small fractional change in the frequency of one laser.

Improved stability is provided if the optical fibre delay line is stabilized against changes in length due to temperature variations. Whilst the length of the delay line determines in one embodiment the stable operating frequencies, a continuous frequency capability over a limited range may be provided. The output frequency may be frequency modulatable.

Embodiments of the invention will now be described, by way of example only, with reference to the drawings, in which:

Figure 1 is a schematic diagram of a frequency synthesizer of the invention arranged to control the frequency of a mixed laser source;

Figure 2 is a graph of the variation with frequency of a phase detector output of the Figure 1 synthesizer;

Figure 3 is a composite graph showing twelve separate output spectra of the Figure 1 synthesizer.

Referring to Figure 1, there is shown a frequency synthesizer of the invention arranged to control a mixed laser radiation source configured as an RF/microwave frequency synthesizer, the synthesizer being indicated generally by 300. A Laser Offset and Locking Accessory (LOLA) unit 302 is connected to two lasers 304 and 306. The LOLA unit 302 is a series 2000 LNC unit made by Lightwave Electronics. It is a power supply for the lasers 304 and 306 and in certain operational modes also acts to lock their difference in frequency to a reference oscillator. The lasers 304 and 306 are Lightwave Electronics devices, diode-pumped Nd:YAG models 123-1319-040-F-W and -B-W respectively. They have peak powers of 40 mW and a maximum frequency separation of 100 GHz.

Radiation from the lasers 304 and 306 is directed to a 50/50 directional coupler 308. Radiation from the laser 306 passes through a polarization controller 309 and subsequently to the coupler 308. The coupler 308 has a central portion 310 comprising two coupled optical fibres, and two outputs 312 and 314. The radiation from the lasers 304 and 306 is combined by evanescent coupling in the central portion 310.

The combined radiation output from output 312 is transmitted to an optical fibre 316 and thence to a radiation detector 318. The detector 318 is a reverse biased PIN diode. The combined radiation output from output 314 passes through a delay line 322. The delay line 322 is a 250 metre length of optical fibre, providing a propagation delay of approximately 1.2 μs. The optical fibre forming the delay line 322 is cladded for improved temperature stability. A second radiation detector 324 is located at an end of delay line 322 remote from output 314 of coupler 308. The detector 324 is a reverse biased PIN diode identical to detector 318. The output of the synthesizer 300 may be taken from either or both of detectors 318 and 324. For clarity of illustration, electrical connections to the detectors 318 and 324 are not shown.

For the mixed laser outputs to give outputs from the detectors 318 and 324 at the beat frequency, it is necessary for the coupler 308 to receive radiation from the two lasers 304 and 306 having the same polarization. The polarization controller 309 is included so that the polarization of light from the laser 306 matches that from the laser 304. The intensity of the detector RF outputs are monitored and the polarization of the radiation from the laser 306 reaching the coupler 308 adjusted using the polarization controller 309 so as to maximise this intensity.

Signal outputs from detectors 318 and 324 are connected to input ports 326 and 328 respectively of a phase detector 330. The phase detector 330 is a dc coupled ANZAC MD141 mixer. It has an output 332 connected via two 10 dB attenuators 334 and 336, an amplifier 338 and a 5.1 kΩ resistor 340 to the LOLA unit 302. The resistor 340 in combination with the capacitive input impedance of the LOLA unit 302 acts as a low pass filter.

If required, low noise amplifiers could be incorporated in the synthesizer 300 to amplify the signal outputs from the detectors 318 and 324 prior to the input ports 326 and 328.

The operation of the synthesizer 300 will now be described. The combining of the lasers in the 50/50 directional coupler 308 results in optical signals having an RF, micro- or millimetre-wave intensity modulation at the beat frequency of the lasers passing from the outputs 312 and 314 to the optical fibre 316 and the delay line 322. The optical signal in each of the fibre 316 and the delay line 322 is converted to an electrical signal by the detectors 318 and 324 respectively. The signal output from the detector 324 is delayed in relation to the signal output from the detector 318 by a time approximately equal to the propagation time of the optical signal through the delay line 322. Consequently, if the modulation frequency of the output from the coupler 308 is varying with time, then the input signals to the phase detector 330 will vary in phase which will in turn result in a time varying output from the phase detector 330. The modulation frequency may vary with time due to a frequency drift in one or both of lasers 304 and 306.

If the modulation frequency is stable with time then the output of the phase detector will be constant in time. In particular, if the modulation frequency is stable with time and the frequency is such that the two inputs to the phase detector are in phase quadrature then the phase detector will produce a null output. "Phase quadrature" means that the signals have the same frequency and waveform but have a phase difference of $\pi/2$ radians.

Figure 2 shows a graph of the variation measured in the open-loop mode of the output of the phase detector 330 with output beat frequency over a range of several MHz. The output has a curve 400 of approximately sinusoidal form. The curve 400 has stable points 402, 404, 406, 408, 410 and 412 and unstable points 414, 416, 418, 420 and 422. The output from the phase detector 330 acts as a controlling voltage input signal to the LOLA unit 302 via attenuators 334 and 336, amplifier 338 and resistor 340. The frequency synthesizer 300 therefore includes a feedback system. If the frequency of mixed radiation is constant in time, and of appropriate value for negligible output from the phase detector 330, then the controlling input voltage signal to the LOLA unit 302 is also very small.

There now follows a simplified description of the operation of the feedback loop. If, for example, the modulation frequency corresponds to point 402 then the output of the phase detector 330 is zero and the output frequency of the synthesizer 300 remains at that frequency. If the modulation frequency drifts to a higher frequency then the response of the phase detector is to produce a negative voltage output. Consequently, the controlling voltage input signal to the LOLA unit 302 is also negative, causing the frequency separation between the output of the lasers 304 and 306 to be reduced, resulting in the modulation frequency decreasing back toward the frequency of the point 402.

Similarly, a decrease in the modulation frequency from point 402 causes the phase detector 330 to produce a positive voltage output. Consequently the controlling or correction voltage input signal to the LOLA unit 302 is positive. This causes the modulation frequency to be increased back towards the frequency of point 402. Thus at the frequency of point 402, any instability of the modulation frequency, whether an increase or a decrease, results in a negative feedback of the synthesizer 300 causing the output frequency to stabilise at a frequency close to that of the point 402. The foregoing consideration also applies when the synthesizer output is set to the other stable points 404 to 412.

Conversely, points 414 to 422 represent unstable points. If the modulation frequency is at the frequency of point 414, then an increase in modulation frequency results in the phase detector producing a positive voltage which increases the modulation frequency even further and stable operation is not possible. Instability at any of the points 414 to 422 results in positive feedback of the synthesizer 300 causing the output frequency to be driven away from an unstable point such as 414.

If the beat frequency of the mixed radiation deviates from a frequency corresponding to that of one of the stable points 402 to 412 then the phase detector 330 produces an output signal such as to change the frequency of one or both of lasers 304 and 306 to oppose the beat frequency fluctuation of the mixed radiation.

The synthesizer 300 has significant advantages over prior art frequency stabilising systems. In prior art systems the individual lasers are stabilized, whereas in the synthesizer 300 it is the beat frequency produced by the mixing of radiation from lasers 304 and 306 which is stabilized. Consequently only one parameter, the beat frequency, needs to be stabilized, whereas in known systems at least two parameters - the individual laser frequencies - need to be stabilized simultaneously.

The output frequencies of the lasers 304 and 306 can be adjusted by electrical control ports on the LOLA unit 302. Alternatively, the temperature of one laser 304 or 306 can be altered using the LOLA unit 302 thermal controls to change its frequency. The temperature changes induced are of the order of 1 GHz per degree celsius. A further option is for combined thermal and electrical control using the LOLA unit 302, in which the thermal controls are used for coarse frequency adjustment and the electrical controls for fine adjustments.

The optical fibres 316 and 322 of Figure 1 may be temperature-stable fibres. Temperature stable fibre is described by R.Kashyap et al. in Electronic Letters Volume 19 Number 24, 1983, pages 1039-1040. The use of temperature stable fibres enables the frequency of the output of the respective sources to be stabilized to a higher degree, as changes in ambient temperature will have a reduced effect on the optical delay paths of the synthesizer 300. Alternatively, the fibres may be placed in a temperature controlled environment, or the optical path length may include an auxiliary temperature dependent path in series with the fibre in order to maintain a constant delay period.

The use of optical fibre 322 in the optical delay path of synthesizer 300 allows for a significantly higher effective quality factor, $Q_F$, to be obtainable than with prior art discriminators particularly at high frequencies. For propagation of 1.3 μm radiation, single mode optical fibre has a loss of approximately 0.4 dB per kilometre. Radiation at this wavelength takes approximately 5 microseconds to travel 1 kilometre in optical fibre, and consequently its attenuation is approximately 0.1 dB per microsecond. For a fibre in which a 3 dB loss is acceptable, this implies a propagation delay of 30 microseconds can be achieved.

The effective quality factor $Q_F$ is given by the following approximate expression:

$$Q_F = \pi f \tau,$$

where f is the frequency of radiation and T the propagation delay. For X-band microwave radiation, at a typical frequency of 10 GHz, and a relative delay of 30 microseconds, $Q_F$ is approximately $10^6$, or one million. This is significantly higher than for prior art synthesizer systems, although such high Q-values will not necessarily be used in practice. This is because for high Q-values the output spectrum is only improved close to the centre frequency. The propagation delay T also determines the separation of stable frequencies $\Delta f$ since $\Delta f = 1/\tau$.

Figure 3 shows a graph of the output RF spectrum at various frequencies. Figure 3 is a composite graph of twelve discrete spectra, each spectrum having a single peak such as peaks 500 and 502 which are spaced in frequency by 0.8 MHz. 0.8 MHz is the reciprocal of the 1.2 μs time delay imposed by the optical fibre 322. The synthesizer 300 can be used to synthesise output frequencies at multiples of approximately 0.8 MHz.

The synthesizer 300 may be provided with tuning means for selecting a given synthesized output frequency. This may be done by means of an auxiliary coarse voltage control to the VCO which may control means for adjusting the temperature of one or both individual lasers. The operation of the feedback loop is to lock the frequency to one of the stable points of the discriminator response of Figure 2.

The synthesizer 300 allows a discrete set of output frequencies to be obtained by controlling the LOLA unit 302 to an approximate value and using the feedback loop to lock the frequency accurately to one of the stable values shown in Figures 2 and 3. Such a discrete frequency selection is valuable for many applications of synthesizers, for example as a local oscillator in an FM radio receiver where a channel spacing of for example 50 kHz is required. In other applications, it is desirable to have greater control over the output frequency. Finer frequency intervals, a continuous tuning capability, or a capability to produce an FM signal may be required. Such capabilities are readily achievable by minor modifications to the synthesizer 300 of Figure 1.

Access to the unstable frequencies 414, 416, 418, 420 and 422 of Figure 2 is readily achievable by inverting the sign of the output of the amplifier 338. If the amplifier 338 is a differential amplifier with two inputs, one of which is grounded, the sign of the output may be inverted by reversing the input connections.

A continuous frequency capability over a limited range may be provided by incorporating a differential amplifier prior to the amplifier 338. The differential amplifier may have a gain of unity and so would have a negligible effect on the operation of the synthesizer if its second input were to be grounded. However, if the second input is connected to a variable voltage $V_2$, the action of the feedback loop is to force the voltage from the phase detector towards $V_2$. From Figure 2, it may be seen that this provides a continuous tuning capability over approximately half the frequency range. By additionally incorporating an inverting capability to the differential amplifier output, essentially continuous frequency coverage is possible. The application of an ac voltage as the input voltage $V_2$ would provide an FM capability. This FM capability would however be restricted to low frequencies as high frequencies would be suppressed by the low-pass filter action of the resistor 340 and the capacitive input impedance of the LOLA unit 302.

An alternative continuous tuning capability may be provided by incorporating an RF phase shifter before one or both of the input ports 326 and 328 of the phase detector 330. Altering the relative phases of the two inputs to the phase shifter 330 has the effect of shifting the curve 400 parallel to the x-axis.

A high frequency FM capability may be achieved by inserting a unity gain differential amplifier immediately prior to the input to the LOLA unit 302, i.e. after any low pass filter. Normally the effect of the feedback loop is to correct for any frequency modulation or instability in the output frequency. In this high frequency FM arrangement however, the correction signal to counteract the effects of the frequency modulation is suppressed by the low-pass filter.

The graph of Figure 2 shows a substantially sinusoidal output. It should be noted, however, that the waveform of frequency discriminator response to frequency changes is of only secondary importance in this invention. The most important parameters of the discriminator response are the frequencies at which the null points such as 402 to 422 occur, as these define the stable and unstable points for discriminator operation and the slopes at the stable frequencies.

In an alternative embodiment, the delay line 322 may be replaced by a suitably configured Fabry-Perot etalon to provide the necessary optical delay.

Whilst the previously described embodiments incorporate Nd:YAG lasers, alternative embodiments of the invention might incorporate solid state lasers, which might be integrated onto a single integrated circuit, thereby reducing fabrication costs.

## Claims

1. A frequency synthesizer (300) for producing an output signal, the synthesizer (300) comprising:

   (i) two coherent optical sources (304, 306), each for generating a respective radiation beam and having an adjustable radiation output frequency, the respective radiation beams being of differing frequency;

   (ii) a beam combiner (310) for combining the two radiation beams to produce two modulated optical signals, the optical signals having a modulation frequency;

   (iii) means (322) for delaying one of the modulated optical signals relative to the other; and

   (iv) control means (302) for controlling the optical sources (304, 306) in response to a detected modulation phase difference between the relatively delayed modulated optical signals.

2. A frequency synthesizer according to Claim 1, characterized in that the means for delaying one optical signal relative to the other is a length of optical fibre (322).

3. A frequency synthesizer according to Claim 2, characterized in that the beam combiner is an optical fibre coupler (310).

4. A frequency synthesizer according to Claim 3, characterized in that the control means comprises:

   (i) two detectors (318, 324), each for producing a respective detector output signal in response to a received modulated optical signal;

   (ii) a phase detector (330) responsive to a phase difference between the detector output signals for producing an output in response thereto; and

   (iii) means (302) responsive to the phase detector output for adjusting the optical sources (304, 306).

5. A frequency synthesizer according to Claim 4, characterized in that the phase detector (330) provides a negative feedback signal to the means (302) responsive to the phase detector.

6. A frequency synthesizer according to Claim 2, characterized in that the length of optical fibre (322) is stabilized against changes in length due changes in temperature.

7. A frequency synthesizer according to Claim 1, characterized in that the frequency synthesizer is arranged to provide an output signal having a frequency which is equal to the modulation frequency and less than 100 GHz.

8. A frequency synthesizer according to Claim 1, characterized in that the coherent optical sources (304, 306) are lasers.

9. A frequency synthesizer according to Claim 8, characterized in that the lasers are Nd:YAG lasers.

10. A frequency synthesizer according to Claim 1, characterized in that the synthesizer includes means for providing a continuous tuning capability.

11. A frequency synthesizer according to Claim 1, characterized in that the output signal is frequency modulatable.

## Patentansprüche

1. Frequenzsynthesizer (300) zum Erzeugen eines Ausgangssignals, wobei der Synthesizer (300) aufweist:

(i) zwei kohärente optische Quellen (304, 306), von denen jede jeweils einen Strahlungsstrahl erzeugt und eine einstellbare Strahlungsausgangsfrequenz hat, wobei die Strahlungsstrahlen unterschiedliche Frequenzen haben;
(ii) einen Strahlkombinierer (310) zum Kombinieren der zwei Strahlungsstrahlen zur Erzeugung zweier modulierter optischer Signale, wobei die optischen Signale eine Modulationsfrequenz haben;
(iii) eine Einrichtung (322) zum Verzögern eines der modulierten optischen Signale bezüglich des anderen; und
(iv) eine Steuerungseinrichtung (302) zum Steuern der optischen Quellen (304, 306) nach Maßgabe einer erfaßten Modulationsphasendifferenz zwischen den relativ verzögerten modulierten optischen Signalen.

**2.** Frequenzsynthesizer nach Anspruch 1, dadurch gekennzeichnet, daß die Verzögerungseinrichtung für ein optisches Signal bezüglich des anderen eine Strecke einer optischen Faser (322) ist.

**3.** Frequenzsynthesizer nach Anspruch 2, dadurch gekennzeichnet, daß der Strahlkombinierer ein optischer Faserkoppler (310) ist.

**4.** Frequenzsynthesizer nach Anspruch 3, dadurch gekennzeichnet, daß die Steuerungseinrichtung aufweist:

(i) zwei Detektoren (318, 324), von denen jeder jeweils ein Detektorausgangssignal nach Maßgabe eines empfangenen modulierten optischen Signals erzeugt;
(ii) einen Phasendetektor (330), der auf die Phasendifferenz zwischen den Detektorausgangssignalen anspricht, um in Abhängigkeit davon eine Ausgabe zu erzeugen, und
(iii) eine Einrichtung (302), die auf die Ausgabe des Phasendetektors anspricht zum Einstellen der optischen Quellen (304, 306).

**5.** Frequenzsynthesizer nach Anspruch 4, dadurch gekennzeichnet, daß der Phasendetektor (330) an die auf den Phasendetektor ansprechende Einrichtung (302) ein gegenkoppelndes Signal liefert.

**6.** Frequenzsynthesizer nach Anspruch 2, dadurch gekennzeichnet, daß die optische Faserstrecke (322) gegen temperaturbedingte Längenänderungen stabilisiert ist.

**7.** Frequenzsynthesizer nach Anspruch 1, dadurch gekennzeichnet, daß der Frequenzsynthesizer dazu ausgelegt ist, ein Ausgangssignal zu liefern, das eine Frequenz hat, die gleich der Modulationsfrequenz und niedriger als 100 GHz ist.

**8.** Frequenzsynthesizer nach Anspruch 1, dadurch gekennzeichnet, daß die kohärenten optischen Quellen (304, 306) Laser sind.

**9.** Frequenzsynthesizer nach Anspruch 8, dadurch gekennzeichnet, daß die Laser Nd:YAG-Laser sind.

**10.** Frequenzsynthesizer nach Anspruch 1, dadurch gekennzeichnet, daß der Synthesizer eine Einrichtung aufweist, mit der er kontinuierlich durchstimmbar ist.

**11.** Frequenzsynthesizer nach Anspruch 1, dadurch gekennzeichnet, daß das Ausgangssignal frequenzmodulierbar ist.

**Revendications**

**1.** Synthétiseur de fréquence (300) pour produire un signal de sortie, le synthétiseur (300) comportant :

(i) deux sources optiques cohérentes (304, 306), chacune destinée à générer un faisceau de rayonnement respectif et ayant une fréquence de sortie de rayonnement ajustable, les faisceaux de rayonnement respectifs ayant de fréquences différentes ;
(ii) un combineur de faisceaux (310) pour combiner les deux faisceaux de rayonnement afin de produire deux signaux optiques modulés, les signaux optiques ayant une fréquence de modulation ;
(iii) des moyens (322) pour retarder l'un des signaux optiques modulés par rapport à l'autre ; et
(iv) des moyens de commande (302) pour commander les sources optiques (304, 306) en réponse à une différence de phase de modulation détectée entre les signaux optiques modulés retardés l'un par rapport à l'autre.

**2.** Synthétiseur de fréquence selon la revendication 1, caractérisé en ce que les moyens pour retarder un signal optique par rapport à l'autre sont une certaine longueur d'une fibre optique (322).

**3.** Synthétiseur de fréquence selon la revendication 2, caractérisé en ce que le combineur de faisceaux est un coupleur à fibres optiques (310).

**4.** Synthétiseur de fréquence selon la revendication 3, caractérisé en ce que les moyens de commande comportent :

(i) deux détecteurs (318, 324), chacun destiné à produire un signal de sortie de détecteur respectif en réponse à un signal optique modulé reçu,
(ii) un détecteur de phase (330) sensible à une différence de phase entre les signaux de sortie du détecteur pour produire une sortie en réponse à celle-ci, et
(iii) des moyens (302) sensibles à la sortie du détecteur de phase pour ajuster les sources optiques (304, 306).

**5.** Synthétiseur de fréquence selon la revendication 4, caractérisé en ce que le détecteur de phase (330) délivre un signal de réaction négative dans les moyens (302) sensibles au détecteur de phase.

**6.** Synthétiseur de fréquence selon la revendication 2, caractérisé en ce que la longueur de fibre optique (322) est stabilisée vis-à-vis de changements de longueur dus à des changements de température.

**7.** Synthétiseur de fréquence selon la revendication 1, caractérisé en ce que le synthétiseur de fréquence est conçu pour délivrer un signal de sortie ayant une fréquence qui est égale à la fréquence de modulation et qui est inférieure à 100 GHz.

**8.** Synthétiseur de fréquence selon la revendication 1, caractérisé en ce que les sources optiques cohérentes (304, 306) sont des lasers.

**9.** Synthétiseur de fréquence selon la revendication 8, caractérisé en ce que les lasers sont des lasers Nd: YAG.

**10.** Synthétiseur de fréquence selon la revendication 1, caractérisé en ce que le synthétiseur comporte des moyens pour fournir une capacité d'accord continue.

**11.** Synthétiseur de fréquence selon la revendication 1, caractérisé en ce que le signal de sortie est modulable en fréquence.

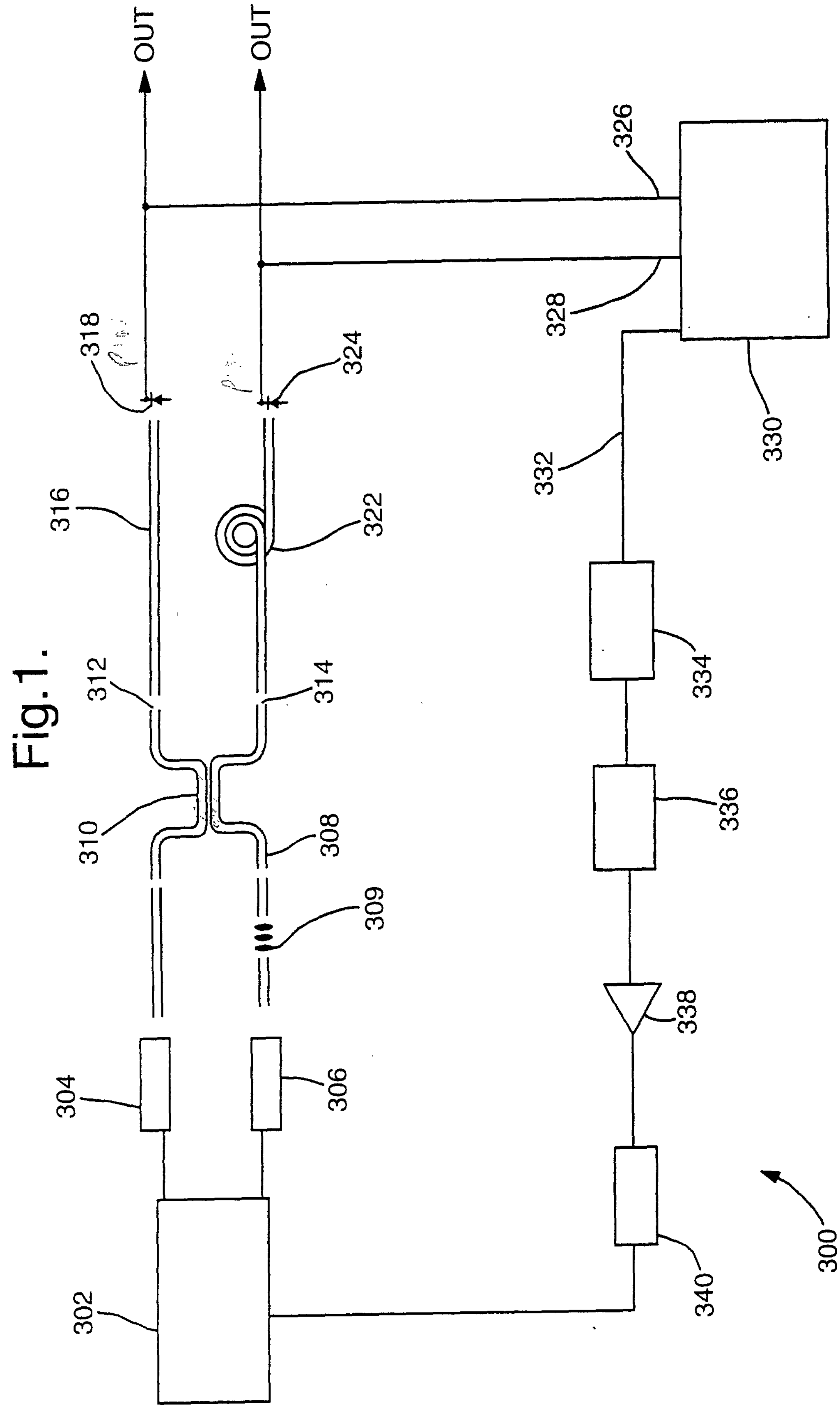
OUT
OUT
326
328
318
324
316
322
330
332
312
314
334
310
308
336
309
338
304
306
302
340
300

Fig.1.

Fig.2.

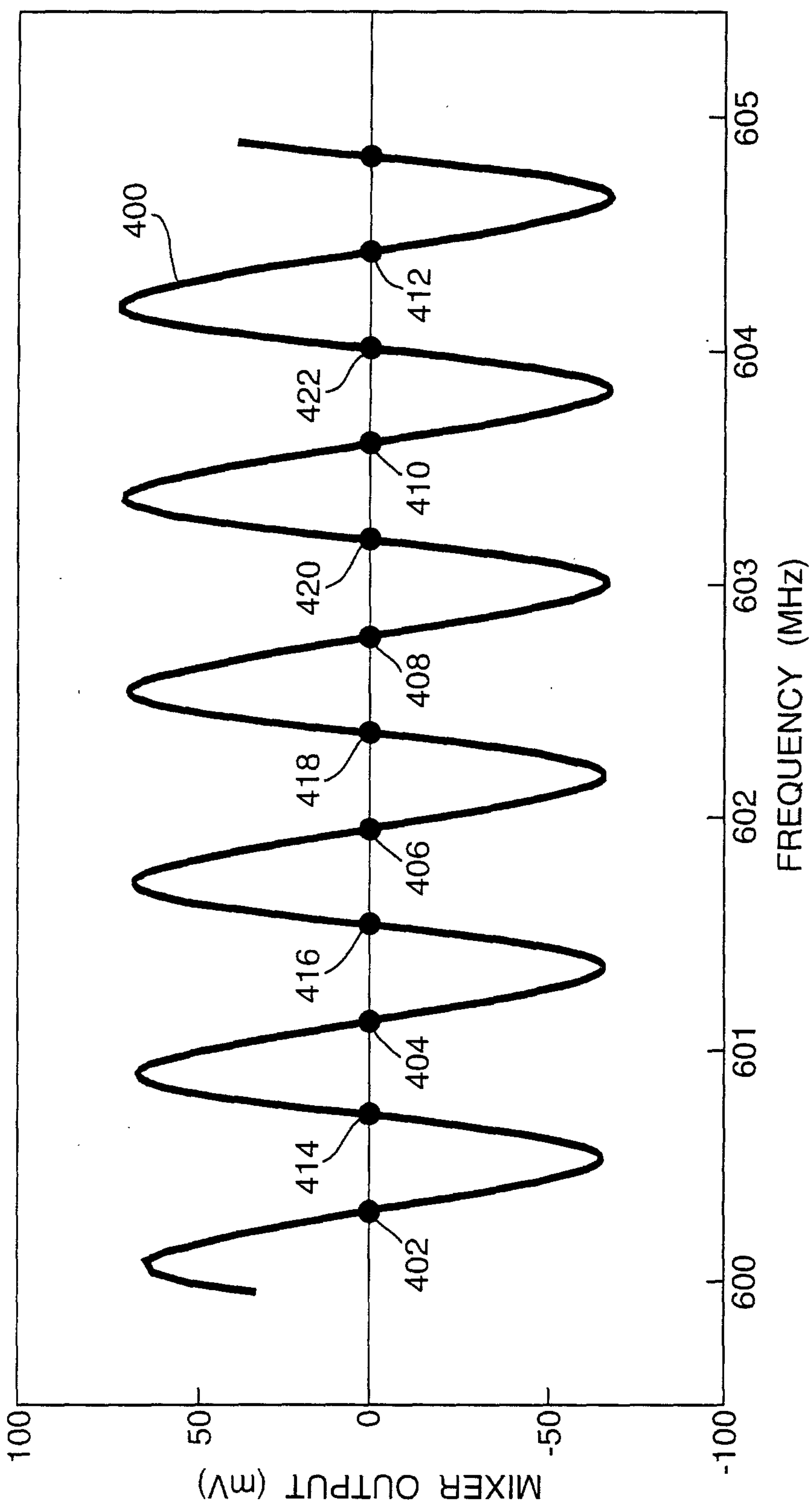
400
402
404
406
408
410
412
414
416
418
420
422
100
50
0
-50
-100
MIXER OUTPUT (mV)
600
601
602
603
604
605
FREQUENCY (MHz)

Fig.3.

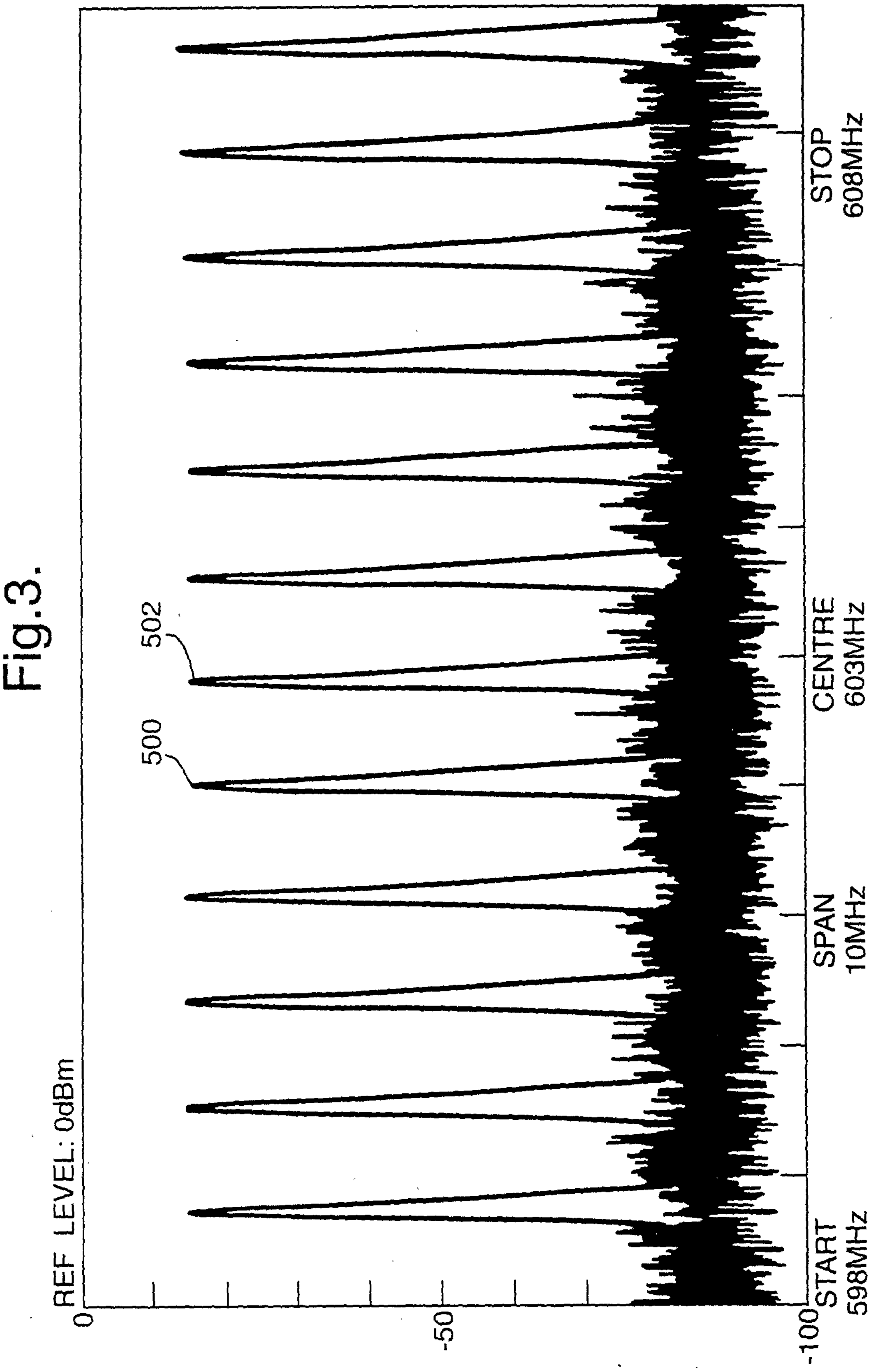
REF LEVEL: 0dBm
0
-50
-100
START
598MHz
SPAN
10MHz
CENTRE
603MHz
STOP
608MHz
500
502